# EUROPÄISCHE PATENTANMELDUNG

(11) **EP 1 720 253 A2**
(43) Veröffentlichungstag der Anmeldung: **08.11.2006**
(21) Anmeldenummer: 06008262.5
(22) Anmeldetag: 21.04.2006
(51) Int. Cl.: H03K 17/955, H03K 17/95

(54) **Berührungslose Schalteranordnung**

(30) Priorität: 04.05.2005 DE 102005021880
(71) Anmelder: Valeo Schalter und Sensoren GmbH, 74321 Bietigheim-Bissingen (DE)
(72) Erfinder: Staude, Sascha, 74321 Bietigheim-Bissingen (DE); Werz, Martin, 74182 Obersulm (DE)
(74) Vertreter: Bulling, Alexander

(57) **Zusammenfassung**

Die Erfindung betrifft eine Schalteranordnung umfassend wenigstens einen kapazitiven oder induktiven Näherungsschalter mit einer aktiven Fläche und eine Auswerteschaltung zur Auswertung des zeitabhängigen Ausgangssignale des Näherungsschalters, wobei bei Annäherung von Objekten an die aktive Fläche ein Schaltsignal erzeugt wird.

Die Erfindung kennzeichnet sich dadurch, dass eine zusätzliche aktive Fläche in einem wenigstens weitgehend außerhalb des Einflussbereichs der Objekte vorgesehen Bereich angeordnet ist, wobei das von der zusätzlichen aktiven Fläche erzeugte Zusatzsignale von der Auswerteschaltung bei der Auswertung des Ausgangssignals berücksichtigt wird.

## Beschreibung

Die Erfindung betrifft eine Schalteranordnung umfassend wenigstens einen kapazitiven oder induktiven Näherungsschalter mit einer aktiven Fläche und eine Auswerteschaltung zur Auswertung des zeitabhängigen Ausgangssignals des Näherungsschalters, wobei bei Annäherung von Objekten an die aktive Fläche ein Schaltsignal erzeugt wird. Die Erfindung betrifft insbesondere einen Fahrzeugschalter mit einer derartigen Schalteranordnung. Bei einem derartigen Schalter kann dann das das Schaltsignal auslösende Objekt beispielsweise ein Finger der das Fahrzeug lenkenden Person sein.

Schalteranordnungen mit Näherungsschalter, die auch als Näherungssensoren bezeichnet werden, sind in vielfältiger Art und Weise bekannt.

Bei kapazitiven Näherungsschaltern wird die aktive Fläche in der Regel von Kondensatorbelägen begrenzt. Nähert sich ein Gegenstand der aktiven Fläche, erhöht sich die Kapazität des Kondensators und das Ausgangssignal des Näherungsschalters ändert sich. Bei induktiven Näherungsschaltern tritt ein von einem Oszillator erzeugtes hochfrequentes elektromagnetisches Wechselfeld aus der aktiven Fläche des Schalters aus. Ein in das Wechselfeld eindringendes Objekt dämpft die Oszillatorspannung, wodurch sich das Ausgangssignal ändert.

Das Schaltverhalten von Näherungsschaltern derartiger Schalteranordnungen ist sehr stark abhängig von äußeren elektromagnetischen Einstrahlungen, der Luftfeuchtigkeit und von der Umgebungstemperatur. Schalteranordnungen, die in Kraftfahrzeugen Verwendung finden, sind hohen elektromagnetischen Einstrahlungen, hohen Luftfeuchtigkeits- und Temperaturänderungen ausgesetzt.

Der vorliegenden Erfindung liegt deshalb die Aufgabe zugrunde, eine eingangs genannte Schalteranordnung, die insbesondere in einem Fahrzeug Verwendung finden kann, derart weiterzubilden, dass sie funktionssicher und möglichst wenigstens weitgehend unabhängig von starken wechselnden elektromagnetischen Einflüssen, von Luftfeuchtigkeits- und Temperaturänderungen betrieben werden kann. Derartige parasitäre Einflüsse sollen möglichst weitgehend ausgeschlossen werden.

Diese Aufgabe wird mit einer Schalteranordnung der eingangs genannten Art dadurch gelöst, dass eine zusätzliche aktive Fläche in einem wenigstens weitgehend außerhalb des Einflussbereichs der Objekte vorgesehenen Bereich angeordnet ist, wobei das von der zusätzlichen aktiven Fläche erzeugte zeitabhängige Zusatzsignal von der Auswerteschaltung bei der Auswertung des Ausgangssignals berücksichtigt wird.

Durch die zusätzliche aktive Fläche können folglich aus parasitären Einflüssen resultierende Störsignale bei der Auswertung des Ausgangssignals des Näherungsschalters berücksichtigt werden. Das von der zusätzlichen aktiven Fläche erzeugte Zusatzsignal ist dabei vorteilhafterweise unabhängig von den ein Schaltsignal erzeugenden Objekten.

Die Schalteranordnung kann dabei beispielsweise Teil eines manuell betätigbaren Fahrzeugschalters für den Fahrzeuginnenraum sein. Die die Schaltsignale auslösenden Objekte sind dann vorteilhafterweise entweder die Finger der die Schalteranordnung betätigenden Person oder von der die Schalteranordnung betätigenden Person bewegte, der Schalteranordnung zugeordnete Bauteile. Solche Bauteile können beispielsweise metallische Schalterkappen sein, die auf vorgegebenen Bahnen bewegt werden.

Die Schalteranordnung kann dabei mehrere nebeneinander angeordnete Näherungsschalter vorsehen, die vom Fahrzeuglenker betätigt werden können. Insofern kann die erfindungsgemäße Schalteranordnung auch als Fahrzeugschalterpaneel mit mehreren Näherungsschaltern ausgebildet sein.

Die Auswerteschaltung ist vorteilhafterweise derart ausgebildet, dass sie das Zusatzsignal von dem Ausgangssignal wenigstens teilweise subtrahiert. Durch die Subtraktion des Zusatzsignals von dem Ausgangssignal wird ein von den parasitären Einflüssen bereinigtes Korrektursignal bereitgestellt, das eindeutige Schaltsignale aufweist.

Gemäß einer Weiterbildung der Erfindung ist denkbar, dass die Auswerteschaltung bei Erreichen eines Schwellwertes des Zusatzsignals den Näherungsschalter deaktiviert. Beispielsweise bei Auftreten von sehr starken elektromagnetischen Feldern kann dann der entsprechende Näherungsschalter so lange deaktiviert werden, bis das elektromagnetische Feld abgeklungen ist. Hierdurch kann verhindert werden, dass eine ungewollte Fehldetektion von Schaltsignalen auftritt.

Gemäß einer Weiterbildung der Erfindung ist denkbar, dass der Näherungsschalter auf einer Seite einer Leiterplatte angeordnet ist und dass die zusätzliche aktive Fläche auf der anderen Seite der Leiterplatte angeordnet ist. Damit befindet sich der Näherungsschalter und die zusätzliche aktive Fläche räumlich nahe beieinander, wobei durch die Leiterplatte die zusätzliche aktive Fläche von Einflüssen der mit dem Näherungsschalter zusammenwirkenden Objekte geschützt ist.

Ferner kann vorgesehen sein, dass eine zusätzliche Abschirmung zum Schutz der zusätzlichen aktiven Fläche vor Einflüssen der Objekte vorgesehen ist. Die zusätzliche Abschirmung kann dabei als Blech oder Gitter ausgebildet sein.

Eine bevorzugte Ausführungsform der Erfindung sieht vor, dass der Näherungsschalter kapazitiv ist und dass die aktive Fläche als offene Elektrode ausgebildet ist. Kapazitive Näherungsschalter haben den Vorteil, dass sie insbesondere nicht metallische Objekte gut erfassen können. Ferner ist die Ausbildung der aktiven Fläche als offene Elektrode vergleichsweise einfach zu realisieren.

Eine weitere vorteilhafte Ausgestaltung der Erfindung sieht vor, dass mehrere, insbesondere federbeaufschlagte kapazitive Näherungsschalter vorgesehen sind, die jeweils zwei Schaltstufen aufweisen, wobei das erste Schaltsignal bei Berühren der Näherungsschalter und das zweite Schaltsignal bei Drücken der Näherungsschalter ausgelöst wird.

Gemäß einer Weiterbildung der Erfindung ist denkbar, dass die Schalteranordnung wenigstens einen Tast-, Dreh oder Kippschalter mit einer manuell betätigbaren Schalthaube umfasst, wobei die aktive Fläche des Näherungsschalters an der Schalthaube angeordnet oder in die Schalthaube integriert sein kann. Der Tast-, Dreh oder Kippschalter kann dabei insbesondere ein mechanischer Schalter sein, der bei Tasten, Drehen oder Kippen einen elektrischen Kontakt mechanisch schließt. Eine derartige Ausbildung hat den Vorteil, dass eine zweistufige Schalteranordnung bereitgestellt wird. Vorteilhafterweise wird beim Berühren der Schalthaube vom Näherungsschalter in einer ersten Schaltstufe ein Schaltsignal generiert. Beim Betätigen der Schalthaube wird dann der Tast-, Dreh oder Kippschalter geschalten, wodurch die zweite Schaltstufe ausgelöst wird.

Vorteilhafterweise sind mehrere Tast-, Dreh oder Kippschalter vorgesehen, wobei jedem Tast-, Dreh oder Kippschalter ein eigener Näherungsschalter zugeordnet ist. Dabei ist insbesondere vorteilhaft, wenn lediglich eine zusätzliche aktive Fläche zur Erfassung der parasitären Einflüsse vorgesehen ist. Eine derartige Schaltanordnung kann insbesondere im Innenbereich eines Kraftfahrzeugs Verwendung finden, da über eine derartige Schaltanordnung viele Schaltfunktionen ausgelöst werden können (zwei Schaltstufen pro betätigbarer Schalthaube), ohne dass Außeneinflüsse die Funktionssicherheit der Schaltvorgänge beeinträchtigen.

Weitere Einzelheiten und vorteilhafte Ausgestaltungen der Erfindung sind der folgenden Beschreibung zu entnehmen, anhand der ein Ausführungsbeispiel der Erfindung näher beschrieben und erläutert ist.

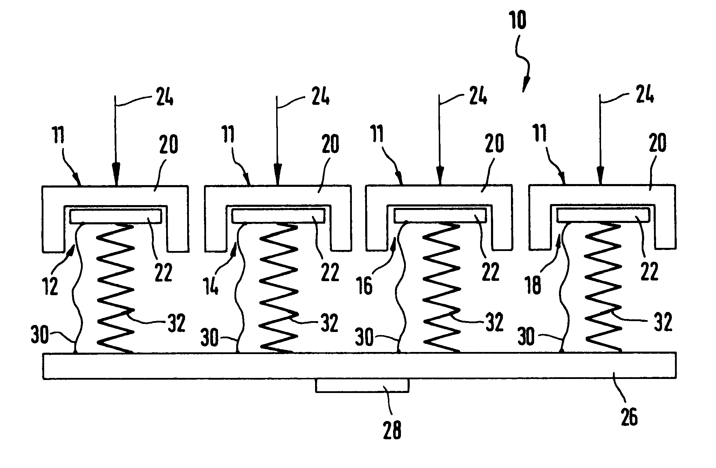

In der Figur ist eine erfindungsgemäße Schalteranordnung 10 in Form eines Fahrzeugschalterpaneels dargestellt, das insgesamt vier Tastschalter 11 mit jeweiliger Schalthaube 20 umfasst. In jeden Tastschalter 11 ist ein kapazitiver Näherungsschalter 12, 14, 16, 18 integriert, der jeweils eine von der jeweiligen Schalthaube 20 abgedeckte aktive Fläche 22 umfasst. Die Näherungsschalter 12, 14, 16, 18 sind so ausgelegt, dass bei Berühren der jeweiligen Schalthaube 20 ein Schaltsignal erzeugt wird. Bei Drücken der Schalthauben in Richtung der Pfeile 24, entgegen der Kraft der Federn 32, wird vom Tastschalter ein weiteres Schaltsignal erzeugt.

Die Tastschalter sind auf einer Leiterplatte 26 angeordnet, auf der auch eine nicht näher dargestellte, die Ausgangssignale der Näherungsschalter und der Tastschalter auswertenden Auswerteschaltung angeordnet ist. Wie aus der Figur deutlich wird, sind die einzelnen aktiven Flächen 22, die unmittelbar auf der Innenseite der jeweiligen Schalthaube 20 angeordnet sind, über einen flexiblen Leiter 30, beispielsweise in Form einer elektrischen Leitung, mit der Leiterplatte 26 beziehungsweise der Auswerteschaltung elektrisch verbunden.

Auf der den Näherungsschaltern abgewandten Seite der Leiterplatte 26 ist eine zusätzliche aktive Fläche 28 in Form einer freien Elektrode angeordnet, die die parasitären Einflüsse, die insbesondere aus fremden elektromagnetischen Feldern, Feuchtigkeits- und Temperaturschwankungen resultieren, berücksichtigt. Die zusätzliche aktive Fläche 28 erzeugt dabei ein von den parasitären Signalen abhängiges, zeitabhängiges Zusatzsignal, das von der Auswerteschaltung bei der Auswertung der Ausgangssignale der Näherungsschalter 12, 14, 16, 18 berücksichtigt wird.

Insbesondere kann vorgesehen sein, dass die Auswerteschaltung das Zusatzsignal der aktiven Fläche 28 von den Ausgangssignalen der Näherungsschalter subtrahiert. Dadurch ergibt sich ein von den parasitären Störeinflüssen bereinigtes Korrektursignal. Bei Auftreten von vergleichsweise starken elektromagnetischen Feldern ist denkbar, dass die Auswerteschaltung zum Schutz vor Fehldetektionen von Schaltsignalen die Näherungsschalter deaktiviert.

Aufgrund der Anordnung der zusätzlichen aktiven Fläche 28 auf der der Schalteranordnungen abgewandten Seite der Leiterplatte wird gewährleistet, dass die zusätzliche aktive Fläche 28 wenigstens weitgehend außerhalb des Einflussbereichs der von den Näherungsschaltern detektierten Objekten liegt. Gegebenenfalls kann zusätzlich eine Abschirmung der zusätzlichen aktiven Fläche 28 vorgesehen sein.

## Patentansprüche

1. Schalteranordnung (10) umfassend wenigstens einen kapazitiven oder induktiven Näherungsschalter (12 - 18) mit einer aktiven Fläche (22) und eine Auswerteschaltung zur Auswertung des zeitabhängigen Ausgangssignals des Näherungsschalters, wobei bei Annäherung von Objekten an die aktive Fläche (22) ein Schaltsignal erzeugt wird, **dadurch gekennzeichnet, dass** eine zusätzliche aktive Fläche (28) in einem wenigstens weitgehend außerhalb des Einflussbereichs der Objekte vorgesehen Bereich angeordnet ist, wobei das von der zusätzlichen aktiven Fläche (28) erzeugte Zusatzsignal von der Auswerteschaltung bei der Auswertung des Ausgangssignals berücksichtigt wird.

2. Schalteranordnung (10) nach Anspruch 1, **dadurch gekennzeichnet, dass** die Auswerteschaltung derart ausgebildet ist, dass sie das Zusatzsignal von dem Ausgangssignal wenigstens teilweise subtrahiert.

3. Schalteranordnung (10) nach Anspruch 1 oder 2, **dadurch gekennzeichnet, dass** die Auswerteschaltung derart ausgebildet ist, dass sie bei Erreichen eines Schwellwertes des Zusatzsignals den Näherungsschalter deaktiviert.

4. Schalteranordnung (10) nach Anspruch 1, 2 oder 3, **dadurch gekennzeichnet, dass** der Näherungsschalter (12 - 18) auf einer Seite einer Leiterplatte (26) angeordnet ist und dass die zusätzliche aktive Fläche (28) auf der anderen Seite der Leiterplatte (26) angeordnet ist.

5. Schalteranordnung (10) nach einem der vorhergehenden Ansprüche, **dadurch gekennzeichnet, dass** eine Abschirmung zum Schutz der zusätzlichen aktiven Fläche (28) vor Einflüssen der Objekte vorhanden ist.

6. Schalteranordnung (10) nach einem der vorhergehenden Ansprüche, **dadurch gekennzeichnet, dass** der Näherungsschalter (12 - 18) kapazitiv ist und dass die aktive Fläche (22) und/oder die zusätzliche aktive Fläche (28) als offene Elektrode ausgebildet ist.

7. Schalteranordnung (10) nach einem der vorhergehenden Ansprüche, **dadurch gekennzeichnet, dass** die Schalteranordnung wenigstens einen Tast-, Dreh oder Kippschalter (11) mit einer betätigbaren Schalthaube (20) umfasst, wobei die aktive Fläche (22) des Näherungsschalters an der Schalthaube (20) angeordnet oder in die Schalthaube (20) integriert sein kann.

8. Schalteranordnung (10) nach einem der vorhergehenden Ansprüche, **dadurch gekennzeichnet, dass** mehrere Tast-, Dreh oder Kippschalter (11) vorgesehen sind, dass jedem Tast-, Dreh oder Kippschalter (11) ein Näherungsschalter (12 - 18) zugeordnet ist und dass lediglich eine zusätzliche aktive Fläche (28) vorgesehen ist.

9. Fahrzeugschalter, insbesondere Schalterpaneel, aufweisend eine Schalteranordnung nach einem der vorhergehenden Ansprüche.
